# EUROPÄISCHE PATENTANMELDUNG

(11) **EP 0 987 755 A2**
(43) Veröffentlichungstag der Anmeldung: **22.03.2000**
(21) Anmeldenummer: 99118398.9
(22) Anmeldetag: 16.09.1999
(51) Int. Cl.: H01L 21/8242

(54) **Gestapelter Flossenkondensator für DRAM und Herstellverfahren dafür**

(30) Priorität: 17.09.1998 DE 19842682
(71) Anmelder: SIEMENS AKTIENGESELLSCHAFT, 80333 München (DE)
(72) Erfinder: Schlösser, Till, Dr., 81825 München (DE); Lange, Gerit, Dr., 81373 München (DE); Franosch, Martin, 81739 München (DE); Wendt, Hermann, Dr., 85630 Grasbrunn (DE)

(57) **Zusammenfassung**

Kondensator mit einem hoch-ε-dielektrischen oder ferroelektrischen Kondensatordielektrikum (9), dessen edelmetallhaltige Speicherelektrode mehrere Lamellen (6₁) aufweist, die über eine Stützstruktur (7) miteinander und ggf. mit dem Träger verbunden sind. Die Stützstruktur kann an einer oder mehreren Außenflanken der Lamellen angeordnet sein, oder sie kann im Innern durch die Lamellen verlaufen. Die Herstellung kann beispielsweise durch Abscheiden einer Schichtenfolge mit alternierend niedriger und hoher Ätzrate (ggf. mit einer Ätzstopschicht im unteren Bereich), Ätzen zur Schichtstruktur, Bilden der Stützstruktur, und selektives Entfernen der Schichten mit hoher Ätzrate erfolgen.

## Beschreibung

Die Erfindung betrifft einen Kondensator in einer integrierten Schaltung mit einer edelmetallhaltigen ersten Elektrode, bei dem als Kondensatordielektrikum ein hoch-ε-Dielektrikum oder ein Ferroelektrikum eingesetzt wird.

In einer großen Anzahl von integrierten Halbleiterschaltungen werden Kondensatoren benötigt, beispielsweise in DRAM-Schaltungen oder A/D-Wandlern. Dabei ist die Erhöhung der Integrationsdichte ein vorrangiges Ziel, d.h. es muß eine möglichst hohe oder für die Anforderungen ausreichende Kapazität mit minimalem Platzbedarf realisiert werden. Dieses Problem stellt sich insbesondere bei DRAM-Schaltungen, bei denen jede Speicherzelle einen Speicherkondensator und einen Auswahltransistor aufweist, wobei die für eine Speicherzelle zur Verfügung stehende Fläche fortlaufend reduziert wird. Gleichzeitig muß zur sicheren Speicherung der Ladung und Unterscheidbarkeit der auszulesenden Information eine gewisse Mindestkapazität des Speicherkondensators erhalten bleiben. Diese Mindestkapazität wird derzeit bei etwa 25 fF gesehen.

Zur Verringerung des Platzbedarfs eines Kondensators kann als Kondensatordielektrikum ein Paraelektrikum mit hoher Permittivität (hoch-ε-Dielektrikum) verwendet werden. In Speicheranordnungen werden solche Kondensatoren vorzugsweise als sogenannte "stacked"-Kondensatoren (der Kondensator der Zelle ist oberhalb des zugehörigen Auswahltransistors angeordnet) eingesetzt. Speicherzellen, die als Kondensatordielektrikum paraelektrische Materialien benutzen, verlieren bei Auswahl der Versorgungsspannung ihre Ladung und somit ihre gespeicherte Information. Ferner müssen diese Zellen wegen des Rest-Leckstroms ständig neu beschrieben werden (Refresh-Time). Der Einsatz eines ferroelektrischen Materials als Kondensatordielektrikum ermöglicht dagegen aufgrund der unterschiedlichen Polarisationsrichtungen des Ferroelektrikums den Bau eines nicht-flüchtigen Speichers (FRAM), der seine Information bei Auswahl der Versorgungsspannung nicht verliert und auch nicht ständig neu beschrieben werden muß. Der Rest-Leckstrom der Zelle beeinflußt nicht das gespeicherte Signal.

Verschiedene hoch-ε-Dielektrika und Ferroelektrika sind aus der Literatur bekannt, beispielsweise Barium-Strontium-Titanat (BST), Strontium-Titanat (ST) oder Blei-Zirconium-Titanat (BZT), ferner ferro- und paraelektrische Polymere und anderes.

Obwohl diese Materialien die gewünschten elektrischen Eigenschaften aufweisen, ist ihre Bedeutung in der Praxis noch begrenzt. Eine wesentliche Ursache dafür ist, daß die genannten Materialien nicht ohne weiteres in Halbleiteranordnungen eingesetzt werden können. Die Herstellung der Materialien erfolgt durch einen Sputter-on- oder Abscheideprozess, der hohe Temperaturen in einer sauerstoffhaltigen Atmosphäre benötigt. Dies hat zur Folge, daß die in der Halbleitertechnologie als Elektrodenmaterial verwendeten leitfähigen Materialien (z.B. Polysilizium, Aluminium oder Wolfram) ungeeignet sind, da sie unter diesen Bedingungen oxidieren. Daher wird zumindest die erste Elektrode üblicherweise aus einem edelmetallhaltigen Material wie Platin oder Ruthenium hergestellt. Diese neuen Elektrodenmaterialen sind jedoch für die Halbleitertechnologie relativ unbekannte Substanzen. Sie sind schwierig aufzubringen und nur bei geringer Schichtdicke befriedigend strukturierbar. Ferner sind sie sauerstoffdurchlässig, was zur Folge hat, daß während der Herstellung des Kondensatordielektrikums tieferliegende Strukturen oxidiert werden und ein ausreichender Kontakt zwischen erster Elektrode und dem Auswahltransistor nicht gewährleistet ist. Daher ist eine Barriere unterhalb des Kondensatordielektrikums notwendig, die eine Sauerstoffdiffusion unterdrückt.

In DE 196 40 448 ist eine derartige Speicherzelle beschrieben, bei der die Barriere zwischen der ersten Elektrode und der Anschlußstruktur zum Auswahltransistor ganzflächig durch eine Nitridation erzeugt wird. In der DE-OS 196 40 244 ist ein Kondensator mit einem hoch-ε-dielektrischen oder ferroelektrischen Kondensatordielektrikum beschrieben, bei dem die erste Elektrode aus einem Elektrodenkern und einer demgegenüber dünnen edelmetallhaltigen Schicht besteht, und bei dem der Elektrodenkern aus dem Material der Anschlußstruktur oder der Oxidationsbarriere besteht. Dies hat den Vorteil, daß lediglich eine dünne edelmetallhaltige Schicht strukturiert werden muß. Allen diesen Kondensatoren mit einem hoch-ε-dielektrischen oder ferroelektrischen Kondensatordielektrikum ist gemeinsam, daß eine im Prinzip planare Anordnung der ersten Elektrode vorgesehen ist.

In US 5,581 436 ist als erste Elektrode eines Kondensators der in Rede stehenden Art eine dünne Platinschicht auf der Oberfläche eines Elektrodenkerns aufgebracht. Ggf. kann das Hoch-ε-Dielektrikum als frei stehende Struktur vor der Bildung der ersten und zweiten Elektrode hergestellt werden, d.h. die Elektroden werden dann an den Seitenwänden des Dielektrikums gebildet.

Aufgabe der vorliegenden Erfindung ist es, bei einem Kondensator mit einem hoch-ε-dielektrischen oder ferroelektrischen Kondensatordielektrikum den Platzbedarf weiter zu verringern, sowie ein einfaches und mit den üblichen Herstellprozessen verträgliches Herstellverfahren für einen solchen Kondensator anzugeben.

Diese Aufgabe wird durch einen Kondensator mit den Merkmalen des Anspruchs 1 bzw. durch Herstellverfahren mit den Merkmalen des Anspruchs 7 oder des Anspruchs 13 gelöst.

Bei der Erfindung umfaßt die erste Elektrode mindestens zwei voneinander beabstandete Lamellen, die im wesentlichen parallel zur Trägeroberfläche liegen und über eine Stützstruktur mit einander verbunden sind. Die kapazitätswirksame Oberfläche ist dadurch gegenüber der beanspruchten Trägeroberfläche wesentlich vergrößert.

Die geometrische Struktur der ersten Elektrode entspricht der Form von sogenannten "Fin-Stack"-Kondensatoren, die aus dotiertem Polysilizium bestehen. Derartige fin-stack-Kondensatoren sind beispielsweise in EP 415 530 B1, EP 779 656 A2, EP 756 326 A1 und in den noch nicht veröffentlichten DE-Patentanmeldungen Nr. 198 21 910.5, 198 21 776.5 und 198 21 777.3 beschrieben. Beispielhaft seien folgende Grundformen genannt:
A) Außenliegende Stützstruktur an einer oder zwei benachbarten Seiten der Lamellen
B) Außenliegende Stützstruktur an drei Seiten
C) Außenliegende Stützstruktur an allen (i.d.R. vier) Seiten
D) Innenliegende Stützstruktur durch die Lamellen hindurch.

Als Material für die erste Elektrode ist insbesondere Platin, aber auch Rutheniumoxid und andere edelmetallhaltige Materialien geeignet, die für den Einsatz in einem hoch-ε- oder ferroelektrischen Kondensator bekannt sind. Die zweite Elektrode besteht vorzugsweise aus demselben Material wie die erste, kann aber auch aus einem anderen geeigneten Material, beispielsweise W oder TiN, einem anderen Metall oder dotiertem Polysilizium, gebildet werden. Die zweite Elektrode des Kondensators ist von der ersten Elektrode durch ein hoch-ε-Dielektrikum oder Ferroelektrikum getrennt.

Der Träger kann einen Anschluß für die erste Elektrode enthalten, wobei die übrige Trägeroberfläche mit einer Isolierschicht bedeckt ist. Dann bedeckt die edelmetallhaltige erste Elektrode (nämlich die unterste Lamelle oder die Stützstruktur) einen Teil der Trägeroberfläche und überdeckt diesen Anschluß, so daß ein elektrischer Kontakt gewährleistet ist.

Vorzugsweise wird der Kondensator in einer DRAM-Zelle eingesetzt. Dann enthält der Träger den zugehörigen MOS-Auswahltransistor. Ein S/D-Gebiet des Transistors wird über den erläuterten Anschluß mit der ersten Elektrode verbunden. Der Anschluß weist vorzugsweise in seinem oberen Bereich eine leitende Sauerstoffbarriere auf (beispielsweise Titannitrid) und besteht im übrigen aus beispielsweise Titan, Polysilizium, Wolfram oder ähnlichem.

Zur Herstellung der ersten Elektrode wird auf einem Träger, der eine Isolationsschicht mit einem darin eingebetteten Anschluß enthalten kann, eine Schichtenfolge erzeugt, die jeweils alternierend eine Schicht aus einem edelmetallhaltigen ersten Material und eine Schicht aus einem zweiten Material aufweist, wobei das zweite Material zum ersten selektiv ätzbar ist. Als zweites Material wird vorzugsweise ein Metall, z.B. Al oder Ti, eingesetzt.

Bei Ausführungsformen mit außenliegender Stützstruktur wird dann die Schichtenfolge bis zum Träger strukturiert, so daß eine Schichtstruktur mit Flanken gebildet wird. Es wird die Stützstruktur an mindestens einer Flanke erzeugt, wozu insbesondere ein anisotropes schräges Aufdampfen oder eine konforme Abscheidung mit anschließender anisotroper Ätzung zur Bildung eines Spacers eingesetzt werden können. Bei dem letzten Verfahren wird dann eine Öffnung in die Schichtstruktur geätzt, um eine Oberfläche der Schichten freizulegen und mit einer selektiven Ätzung die Schichten aus dem zweiten Material entfernen zu können.

Die Öffnung kann an den Rand der Schichtstruktur gelegt werden, so daß hier die die Stützstruktur bildende Schicht (bzw. Spacer) und evtl. ein Randbereich der Schichtstruktur entfernt werden.

Die Öffnung kann andererseits vollständig, insbesondere zentral im Innern der Schichtstruktur erzeugt werden. Dadurch wird eine besonders hohe Stabilität beim Herausätzen des zweiten Materials gewährleistet, da die Stützstruktur an allen außenliegenden Flanken des Stützgerüstes vorhanden ist. Die Schichten aus dem zweiten Material können daher sehr dünn sein, bspw. 20 - 30 nm.

Die Öffnung kann auch so in bzw. durch das Innere der Schichtstruktur gelegt werden, daß sie die Schichtstruktur in zwei Teilbereiche trennt. Jeder der Teilbereiche wird dann als eine erste Elektrode eines Kondensators verwendet. Mit anderen Worten, die Schichtstruktur wird anfangs so erzeugt, daß sie die lateralen Ausmaße von zwei benachbarten Kondensatoren aufweist, und wird dann bei der Bildung der Öffnung in zwei Elektroden separiert. Jede Elektrode ist dann an drei Flanken (Außenseiten) mit einer Stützstruktur versehen, wodurch ebenfalls eine gute mechanische Stabilität gewährleistet ist.

In anderen Ausführungsformen der Erfindung wird die Stützstruktur im Innern der Elektrode gebildet. Dazu wird wie in der ersten Ausführungssform die Schichtenfolge auf dem Träger gebildet. In der Schichtenfolge wird eine Öffnung gebildet und vorzugsweise mit dem ersten Material aufgefüllt, so daß in der Öffnung eine Stützstruktur erzeugt wird. Anschließend wird die Schichtenfolge anisotrop entsprechen den Ausmaßen der zu erzeugenden Elektrode zu einer Schichtstruktur geätzt. An den Außenflanken liegen die Schichten aus dem ersten und dem zweiten Material frei. Mit Hilfe einer zum ersten Material und zur Stützstruktur selektiven Ätzung werden die Schichten aus dem zweiten Material entfernt. Dabei wird ein Ätzprozeß mit isotroper Komponente eingesetzt. Die verbleibenden Schichten aus dem ersten Material und die sie elektrisch verbindende Stützstruktur bilden die erste Elektrode.

Nach Erzeugung der ersten Elektrode wird in allen Ausführungsformen ein hoch-ε-Dielektrikum oder Ferroelektrikum auf die erste Elektrode aufgebracht. Darauf wird die Gegenelektrode erzeugt, dabei werden die Hohlräume zwischen den Lamellen aufgefüllt.

Als unterste oder zweitunterste Schicht der Schichtenfolge kann eine Ätzstopschicht aufgebracht werden. Diese Ätzstopschicht wird vor, gleichzeitig oder nach der selektiven isotropen Ätzung der Schichten aus dem zweiten Material entfernt. Die an die Ätzstopschicht angrenzende Schicht oder Schichten der Schichtenfolge ist (sind) dann vorzugsweise eine Schicht aus dem ersten Material. Die Ätzung zur Bildung der Schichtstruktur kann dann ebenso wie die Erzeugung der Öffnung in zwei oder auch drei Ätzschritten erfolgen, wobei der erste Ätzschritt selektiv zur Ätzstopschicht ist. Ein evtl. im Träger vorhandenes Kontaktloch bzw. Barriere oder auch die Trägeroberfläche selber wird durch dises Verfahren besonders gut geschützt. Dabei hängt es von der Wahl des ersten und zweiten Materials, der Barriere und der Trägeroberfläche ab, ob der Einsatz einer Ätzstopschicht vorteilhaft ist.

Die Herstellung der Schichtenfolge (Pt, Al)kann beispielsweise durch Sputtern oder durch ein CVD-Verfahren erfolgen. Als anisotropes Ätzverfahren einer Schichtenfolge aus Pt und Al kann RIE eingesetzt werden mit Cl₂, Ar, SiCl₄ oder PCL₃. Die selektive isotrope Ätzung von Al erfolgt mit H₃PO₄/HNO₃/H2O oder HCl, dabei liegt das Ätzratenverhältnis bei mindestens 1:100. Ti kann mit NH₄OH/H₂O₂ isotrop und selektiv zu einer edelmetallhaltigen Schicht geätzt werden. Die Selektivität zu einer aus Siliziumoxid bestehenden Trägeroberfläche liegt bei ≥ 1:100.

Die Erfindung wird im folgenden anhand der Figuren und der Ausführungsbeispiele näher erläutert. Es zeigen:
Figur 1 - 4 einen Querschnitt durch ein Substrat, an dem ein erstes Ausführungsbeispiel des Verfahrens anhand einer DRAM-Speicherzelle verdeutlicht wird.
Figur 5 - 6 zeigt entsprechend ein zweites Ausführungsbeispiel.
Figur 7 - 12 zeigt ein drittes Ausführungsbeispiel
Figur 13 - 14 zeigt ein viertes Ausführungsbeispiel
Figur 15 - 19 zeigt ein fünftes Ausführungsbeispiel.
Figur 20 - 24 zeigt ein sechstes Ausführungsbeispiel.

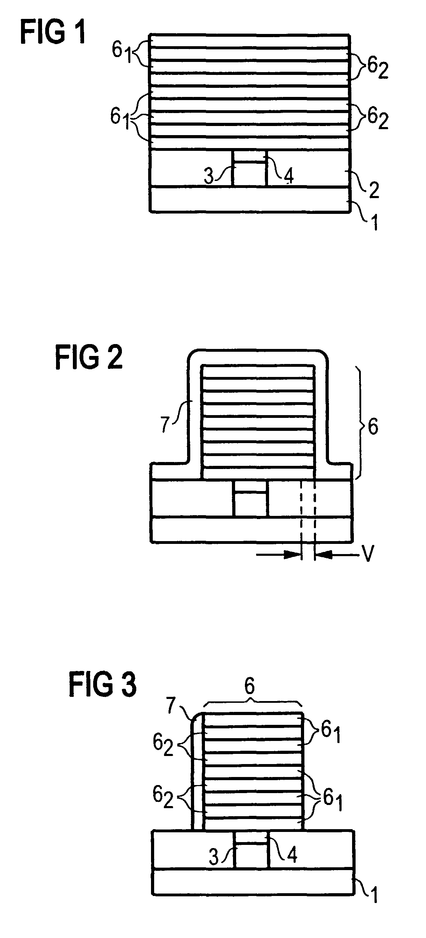

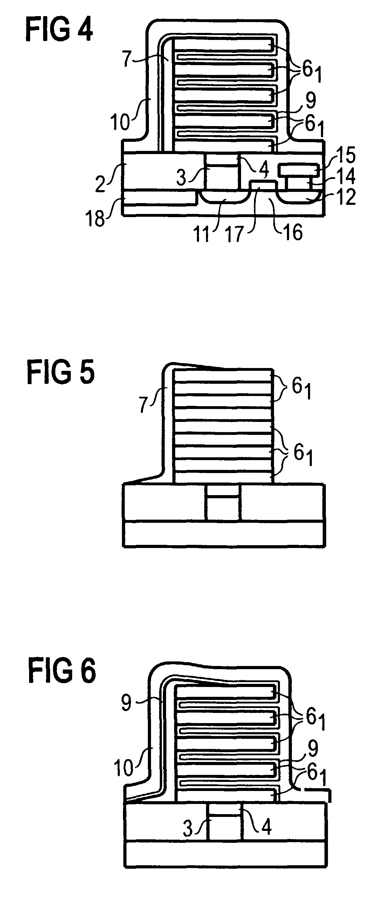

FIG 1: Auf ein Substrat 1 wird eine isolierende Schicht 2 aufgebracht. Das Substrat 1 ist beispielsweise ein Silizium-substrat, das Auswahltransistoren mit Wortleitungen und Bitleitungen umfaßt (s. Fig.4). Die isolierende Schicht wird beispielsweise aus Siliziumoxid gebildet und planarisiert. In der isolierenden Schicht 2 werden Kontaktlöcher 3 geöffnet und mit elektrisch leitfähigem Material, beispielsweise mit dotiertem Polysilizium, Wolfram, Tantal, Titan, Titannitrid oder Wolframsilizid aufgefüllt. Die Kontaktlöcher 3 werden so angeordnet, daß sie jeweils auf ein Source-/Draingebiet eines Auswahltransistors im Substrat 1 reichen. Vorzugsweise im oberen Teil des Kontaktlochs 3 ist eine Barriere 4 angeordnet, die eine Sauerstoffdiffusion unterdrückt. Verfahren zur Herstellung einer solchen Barriere sind beispielsweise aus DE-196 40 246, DE-196 40 448 bekannt. Auf der Oberfläche dieses Trägers wird nun eine Schichtenfolge aufgebracht, die alternierend eine Schicht 6₁ aus einem edelmetallhaltigen ersten Material und eine Schicht 6₂ aus einem zweiten Material umfaßt. Beispielsweise besteht das erste Material aus Platin und das zweite Material aus Aluminium. Diese Schichten können in einer Sputteranlage direkt nacheinander aufgebracht werden, indem lediglich das Target gewechselt wird und die Parameter des Sputterprozesses angepaßt werden. In dieser Ausführungsform muß das zweite Material selektiv zum ersten Material und zur Trägeroberfläche 2 ätzbar sein, nicht aber zum Barrierenmaterial. In diesem Ausführungsbeispiel wird direkt auf die Trägeroberfläche die Schicht aus dem ersten Material aufgebracht, die oberste Schicht der Schichtenfolge besteht aus dem ersten Material.

FIG 2: Anschließend wird aus der Schichtenfolge durch anisotropes Ätzen unter Verwendung einer Maske eine Schichtstruktur 6 gebildet, deren laterale Ausmaße den herzustellenden Kondensatorlamellen zuzüglich eines definierten Vorhaltes V an mindestens einer Seite entsprechen. In der dazu senkrechten lateralen Richtung entspricht die Ausdehnung der Schichtstruktur vorzugsweise der der Kondensatorlamellen. Neben der Schichtstruktur liegt die Oberfläche der isolierenden Schicht 2 frei. Für den Ätzprozeß kann Cl₂, Ar, SiCl₄ oder PCl₃ eingesetzt werden. Dann wird eine Schicht 7 vorzugsweise aus dem ersten Material konform abgeschieden, wobei die Schichtdicke im Bereich 10 - 100 nm liegt. Ein geeignetes Abscheideverfahren ist z.B. CVD.

FIG 3: Aus der abgeschiedenen Schicht aus dem ersten Material werden durch anisotropes Rückätzen an den Seitenwänden der Schichtstruktur 6 Spacer 7 gebildet. Das anisotrope Ätzen kann durch Sputterätzen erfolgen. Anschließend wird die Schichtstruktur mit den Spacern 7 unter Verwendung einer photolithographisch erzeugten Maske durch anisotropes Ätzen so strukturiert, daß an einer Seite der Spacer 7 und ein Teil der Schichtstrukur 6, nämlich der vorher festgelegte Vorhalt V, entfernt werden. An dieser Seite weist die Schichtstruktur dann eine Flanke auf, an der eine Oberfläche der Platinschichten 6₁ und der Aluminiumschichten 6₂ freiliegt. Mit anderen Worten, es wird eine Öffnung in die Schichtstruktur geätzt, die an die Seite der Struktur gelegt wird. Der verbleibende Spacer 7 stellt die Stützstruktur dar.

FIG 4: Die Schichten 6₂ aus dem zweiten Material werden mit einem Ätzprozeß mit isotroper Komponente entfernt, der die Schichten aus dem ersten Material, die Stützstruktur 7 und die Trägeroberfläche 2 und nicht angreift. Die Barriere 4 ist durch die unterste Schicht aus dem ersten Material geschützt. Auf diese Weise ist eine erste Elektrode gebildet, die aus voneinander beabstandeten Lamellen 6₁ und der Stützstruktur 7 besteht. Die Stützstruktur 7 verbindet die Lamellen 6₁ mechanisch und elektrisch miteinander und mit der Trägeroberfläche. Der Kontakt zum Anschluß 3,4 erfolgt über die unterste Kondensatorlamelle. Dann wird das Kondensatordielektrikum 9 bestehend aus einem hoch-ε-Dielektrikum oder einem Ferroelektrikum wird mit einem bekannten Verfahren aufgebracht. Der dabei eingesetzte Hochtemperaturprozess führt nicht zur Oxidation tieferliegender Strukturen, da eine Sauerstoffdiffusion durch die Barriere 4 vermieden wird. Schließlich wird eine leitende Schicht zur Bildung der Gegenelektrode 10 aufgebracht.

In dieser Figur 4 sind auch weitere im Träger realisierte Strukturen dargestellt, die bei Einsatz des Kondensators in einer DRAM-Schaltung vorhanden sind. Die erste Elektrode 6₁, 7 bildet den sogenannten Speicherknoten für einen Speicherkondensator. Diese erste Elektrode ist über den darunter angeordneten und mit der Diffusionsbarriere 4 versehenen Kontakt 3 mit einem Source-/Drain-Gebiet 11 eines Auswahltansistors verbunden. Das andere Source-/Drain-Gebiet 12 des Auswahltransistors ist über einen Bitleitungskontakt 14 mit einer vergrabenen Bitleitung 15 verbunden. Vorzugsweise besitzen zwei benachbarte Speicherzellen einen gemeinsamen Bitleitungskontakt. Die vergrabene Bitleitung 15 und der Bitleitungskontakt 14 sind von der isolierenden Schicht 2 umgeben. Zwischen den Source-/Drain-Gebieten 11 und 12 eines Auswahltransistors sind das Kanalgebiet 16, ein Gatedielektrikum (nicht dargestellt) und eine als Wortleitung 17 wirkende Gateelektrode angeordnet. Die Wortleitung 17 und der Bitleitungskontakt 14 sind jeweils aus dotiertem Polysilizium gebildet. Die Bitleitung 15 wird aus dotiertem Polyslilizium, Wolframsilizid oder Wolfram gebildet. Auf der der Bitleitung 15 abgewandten Seite des S-/D-Gebietes 11 ist jeweils eine Isolationsstruktur, beispielsweise ein flacher mit isolierendem Material gefüllter Graben 18 zur Isolation zwischen benachbarten Auswahltransistorpaaren vorgesehen.

Für die folgenden Ausführungsbeispiele wird von der in Fig 1 dargestellten Struktur ausgegangen.

FIG 5: (2. Ausführungsbeispiel) Eine weitere Möglichkeit ist die Erzeugung des Verbindungsteils durch ein anisotropes schräges Aufdampfen einer leitenden Schicht, insbesondere aus dem ersten Material, auf eine Seitenwand der Schichtstruktur 6. Dazu wird aus der Schichtenfolge 6₁, 6₂ eine Schichtstruktur 6 durch anisotropes Ätzen erzeugt, deren laterale Ausmaße den herzustellenden Kondensatorlamellen entsprechen. Dann wird auf eine oder zwei Außenflanken der Schichtstruktur unter einem unter einem vorgegebenen Winkel Platin aufgedampft, wobei eine Elektronenstrahl-Verdampfung bei etwa 10⁻⁴ Pa eingesetzt wird. Es wird eine Stützstruktur 7 in einer Schichtdicke von etwa 10 - 100 nm gebildet, an den gegenüberliegenden Außenflanken liegen eine Oberfläche der Schichten aus dem ersten und zweiten Material frei. Das bedeutet, daß ohne Ätzung einer Öffnung eine einseitig geöffnete Schichtstruktur vorliegt. Es kann aber auch eine kurze anisotrope Ätzung ganzflächig, also ohne Fototechnik, durchgeführt werden, um eine evtl. dünne Pt-Schicht auf horizontalen Flächen zu entfernen.

FIG 6: Die Schichten 6₂ aus dem zweiten Material werden mit einem Ätzprozeß mit isotroper Komponente entfernt, der die Schichten aus dem ersten Material, die Stützstruktur 7 und die Trägeroberfläche 2 und nicht angreift. Die Barriere 4 ist durch die unterste Schicht aus dem ersten Material geschützt. Auf diese Weise ist eine erste Elektrode gebildet, die aus voneinander beabstandeten Lamellen 6₁ und der Stützstruktur 7 besteht. Die Stützstruktur 7 verbindet die Lamellen 6₁ mechanisch und elektrisch miteinander und mit der Trägeroberfläche. Der Kontakt zum Anschluß 3,4 erfolgt über die unterste Kondensatorlamelle. Dann wird das Kondensatordielektrikum bestehend aus einem hoch-ε-Dielektrikum oder einem Ferroelektrikum 9 mit einem bekannten Verfahren aufgebracht. Der dabei eingesetzte Hochtemperaturprozess führt nicht zur Oxidation tieferliegender Strukturen, da eine Sauerstoffdiffusion durch die Barriere 4 vermieden wird. Schließlich wird eine leitende Schicht zur Bildung der Gegenelektrode 10 aufgebracht. Selbstverständlich sind bei Einsatz in einer DRAM-Zelle die lediglich in Fig 4 dargestellten Strukturen im Substrat hier und bei allen anderen Ausführungsbeispielen ebenfalls realisiert.

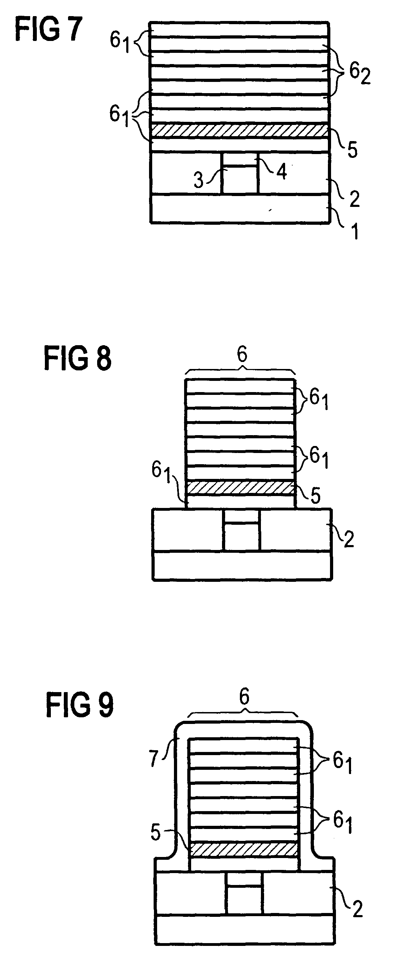

FIG 7: Bei diesem 3. Ausführungsbeispiel wird eine Stützstruktur an allen Außenflanken der Schichtstruktur 6 gebildet. Ferner wird beispielhaft der Einsatz einer Ätzstopschicht, die grundsätzlich bei allen Ausführungsbeispielen verwendet werden kann, erläutert. Auf den Träger, der wie bei Fig 1 erläutert ein Si-Substrat, eine isolierende Schicht 2, einen Anschluß 3 mit Barriere 4 umfaßt, wird eine Schichtenfolge aufgebracht, die alternierend eine Schicht 6₁ aus einem ersten Material und eine Schicht 6₂ aus einem zweiten Material umfaßt. Direkt auf der Trägeroberfläche befindet sich eine Schicht aus dem ersten Material. Anstelle der untersten Schicht aus dem zweiten Material kann auch eine Ätzstopschicht 5 aufgebracht werden, d.h. die zweitunterste Schicht besteht nicht aus dem zweiten Material, sondern aus einem Material, zu dem das erste und das zweite Material selektiv ätzbar sind. Beispielsweise besteht das erste Material aus Pt, das zweite Material aus Al und die Ätzstopschicht 5 aus TEOS oder Nitrid. Ferner kommt eine RuO/Ti-Schichtenfolge in Frage. Die Schichten können durch Sputter-Prozesse hergestellt werden. In diesem Ausführungsbeispiel besteht die oberste Schicht der Schichtenfolge aus dem ersten Material.

FIG 8: Anschließend wird aus der Schichtenfolge (einschließlich der Ätzstopschicht 5) durch anisotropes Ätzen unter Verwendung einer Maske eine Schichtstruktur 6 gebildet, dabei wird - ggf. in zwei oder drei Ätzschritten- auch die Ätzstopschicht 5 geätzt. Das anisotrope Ätzen kann als Sputterätzung durchgeführt werden, für die Ätzung der Ätzstopschicht kann ein übliches Verfahren eingesetzt werden. Neben der Schichtstruktur 6 liegt die Oberfläche der isolierenden Schicht 2 frei.

FIG 9: Auf die gesamte Anordnung wird eine Schicht 7 aus dem ersten Material konform aufgebracht. Dadurch werden alle Außenflanken der Schichtstruktur 6 mit der Schicht 7 bedeckt.

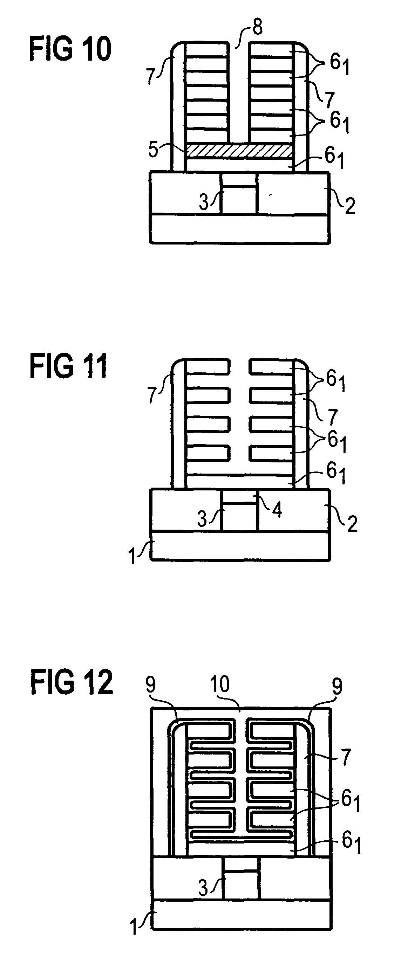

FIG 10: Mithilfe einer ganzflächigen anisotropen Ätzung wird aus der Schicht 7 ein Spacer geätzt, der die Stützstruktur 7 bildet. Dann wird unter Einsatz einer Fotomaske eine Öffnung 8 in die Schichtstruktur geätzt, die eine Oberfläche der Schichten aus dem ersten und aus dem zweiten Material freilegt. In diesem Ausführungsbeispiel wird diese Öffnung in das Innere der Struktur gelegt. Dabei wird zunächst in einem anisotropen Ätzschritt die Schichtenfolge bis zur Ätzstopschicht 5 geätzt.

FIG 11: Dann wird in einem Ätzschritt mit isotroper Komponente die Ätzstopschicht 5 selektiv zum ersten Material entfernt Die Schichten 6₂ aus dem zweiten Material werden mit einem Ätzprozeß mit isotroper Komponente entfernt, der die Schichten aus dem ersten Material und die Stützstruktur 7 nicht angreift (ggf. vor, nach oder gleichzeitig mit der Entfernung der Ätzstopschicht 5). Auf diese Weise ist eine erste edelmetallhaltige Elektrode fertiggestellt. Die Stützstruktur 7 verbindet die Lamellen 6₁ an allen Außenseiten der Elektrode mechanisch und elektrisch miteinander. Der elektrische Kontakt zum Anschluß 3,4 erfolgt über die unterste Lamelle der Elektrode, die den Anschluß sicher überdeckt. Ein An- oder Durchätzen der untersten Lamelle bei der Bildung der Öffnung 8 und damit die Gefahr eines schlechten Kontaktes wird durch die Verwendung der Ätzstopschicht 5 ausgeschlossen.

FIG 12: Anschließend wird der Kondensator wie in den vorherigen Beispielen fertiggestellt (Erzeugung des Kondensatordielektrikums und der Gegenelektrode).

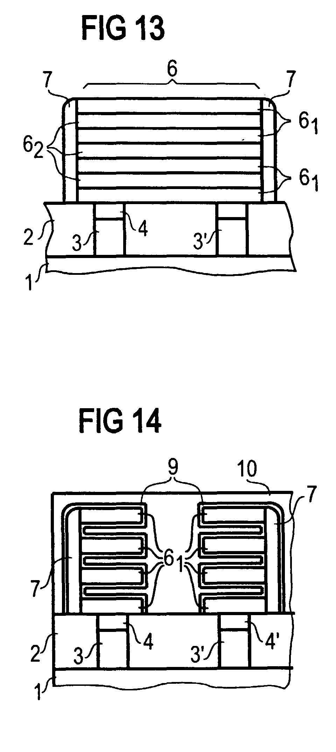

FIG 13: In diesem 4. Ausführungsbeispiel weist die erste Elektrode eine geometrische Form auf, wie sie in der EP 0779 656 A2 dargestellt ist. Das dort zu den Figuren 7 bis 14 beschriebene Herstellverfahren kann im wesentlichen übernommen werden, wobei der Anschluß (dort mit 23 bezeichnet) mit einer Barriere versehen wird und die Materialien der Schichtenfolge und der Stützstruktur sowie die eingesetzte Ätzprozesse entsprechend der vorliegenden Erfindung geändert werden. Ausgehend von Figur 1 wird die Schichtenfolge zu einer Schichtstruktur 6 geätzt, die zwei benachbarte Anschlüsse 3, 3' überdeckt und das laterale Ausmaß von zwei benachbarten Kondensatoren (bzw. ihrer Lamellen) aufweist. An den Flanken der Schichtstruktur 6 werden Spacer 7 als Stützstruktur erzeugt. Geeignete Ätzprozesse und Abscheideprozesse sind beim ersten Ausführungsbeispiel angegeben. Die Oberfläche der isolierenden Schicht 2 liegt außerhalb der Schichtstrukturen 6 und der Stützstrukturen 7 frei.

FIG 14: Unter Verwndung einer photolithographisch erzeugten Maske wird die Schichtstruktur 6 durch anisotropes Ätzen einer Öffnung in zwei Teilbereiche geteilt, die durch einen Spalt voneinander getrennt sind. Im Bereich des Spaltes liegt die Oberfläche der isolierenden Schicht 2 frei. Die Teilbereiche weisen hier eine freigelegt Oberfläche der Schichten der Schichtenfolge auf. Die verbleibenden Spacer 7 stellen jeweils eine Stützstruktur 7 für jeden Teilbereich dar. Die Schichten 6₂ aus dem zweiten Material werden mit einem Ätzprozeß mit isotroper Komponente entfernt, der die Schichten aus dem ersten Material, die Stützstrukturen 7 und die Trägeroberfläche 2 und nicht angreift. Die Barriere 4 ist durch die unterste Schicht aus dem ersten Material geschützt. Auf diese Weise sind zwei benachbarte erste Elektroden gebildet, die jeweils aus voneinander beabstandeten Lamellen 6₁ und der Stützstrukur 7 bestehen und voneinander durch den Spalt getrennt sind. Die Stützstruktur 7 verbindet die Lamellen 6₁ jeweils eines Kondensators an drei Seiten mechanisch und elektrisch miteinander und mit der Trägeroberfläche. Der Kontakt zum jeweiligen Anschluß 3,4 erfolgt jeweils über die unterste Kondensatorlamelle. Dann wird das Kondensatordielektrikum bestehend aus einem hoch-ε-Dielektrikum oder einem Ferroelektrikum 9 wird mit einem bekannten Verfahren aufgebracht. Der dabei eingesetzte Hochtemperaturprozess führt nicht zur Oxidation tieferliegender Strukturen, da eine Sauerstoffdiffusion durch die Barriere 4, 4' vermieden wird. Schließlich wird eine leitende Schicht zur Bildung der Gegenelektrode 10 aufgebracht.

Bei den folgenden Ausführungsbeispielen (5 und 6) werden die Kondensatorlamellen durch eine im Innern verlaufende Stützstruktur mechanisch und elektrisch miteinander verbunden. Es werden dieselben Bezugszeichen wie in den bisherigen Beispielen verwendet; lediglich die Unterschiede zu den bereits erläuterten Verfahren werden näher dargestellt.

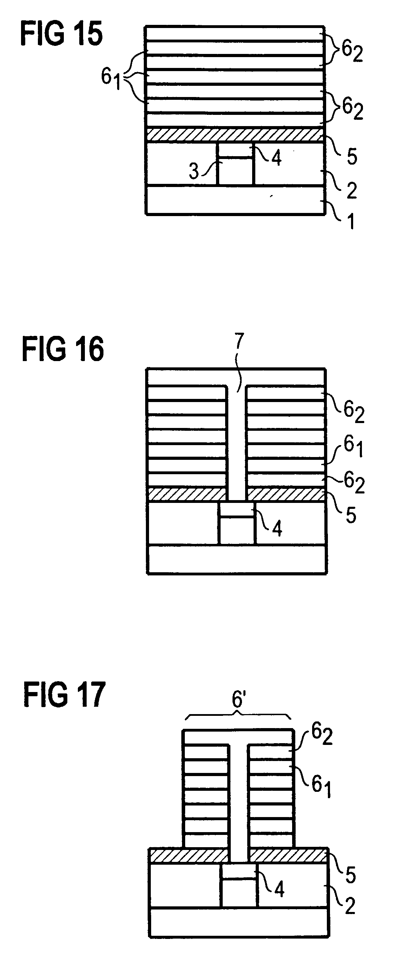

FIG 15: Auf der isolierenden Schicht 2 wird als unterste Schicht der Schichtenfolge eine Ätzstopschicht 5 , bspw. aus TEOS oder Nitrid mit einer Schichtdicke von ca. 50 nm, gebildet. Die darüberliegende Schicht der Schichtenfolge ist hier ebenso wie die oberste Schicht eine Schicht 6₂ aus dem zweiten Material, beide können aber auch aus dem ersten Material bestehen.

FIG 16: In die Schichtenfolge wird eine Öffnung bis zur Ätzstopschicht 5 geätzt. Dazu kann ein Ätzprozeß mit chlorhaltigen Gasen wie oben beschrieben eingesetzt werden. In einem zweiten Ätzschritt wird die Ätzstopschicht 5 mit C₂F₆/CHF₃ durchgeätzt und die Barriereschicht 4 des Anschlusses freigelegt. Der Ätzschritt wird so gewählt, daß eine Schädigung der Barriere vermieden wird. Die Öffnung wird mit dem ersten Material aufgefüllt, vorzugsweise wird auch auf der horizontalen Obefläche der Schichtenfolge das erste Material abgeschieden.

FIG 17: Anschließend wird in einem anisotropen, zur Ätzstopschicht selektiven Ätzprozeß die Schichtenfolge 6₁, 6₂ zur Schichtstruktur 6 strukturiert.

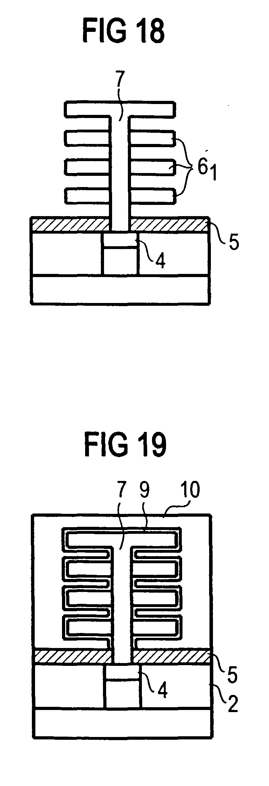

FIG 18: Das Freiätzen der Lamellen 6₁ erfolgt wie oben beschrieben, wobei die Ätzung selektiv zum ersten Material und zur Ätzstopschicht ist. Bei Verwendung von Ti kann bspw. eine Naßätzung mit NH₄OH/H₂O₂ eingesetzt werden, die Selektivität beträgt mindestens 1:100 zu Pt und mindestens 1:100 zu Nitrid als Ätzstopschicht.

FIG 19: Die Ätzstopschicht kann, insbesondere wenn auf ihr eine Schicht 6₂ aus dem zweiten Material angeordnet war, auf dem Träger verbleiben. Der Kondensator wird durch die Bildung des hoch-ε-Dielektrikum 9 oder Ferroelektrikum auf den freien Oberflächen und die Erzeugung der Gegenelektrode 10 fertiggestellt.

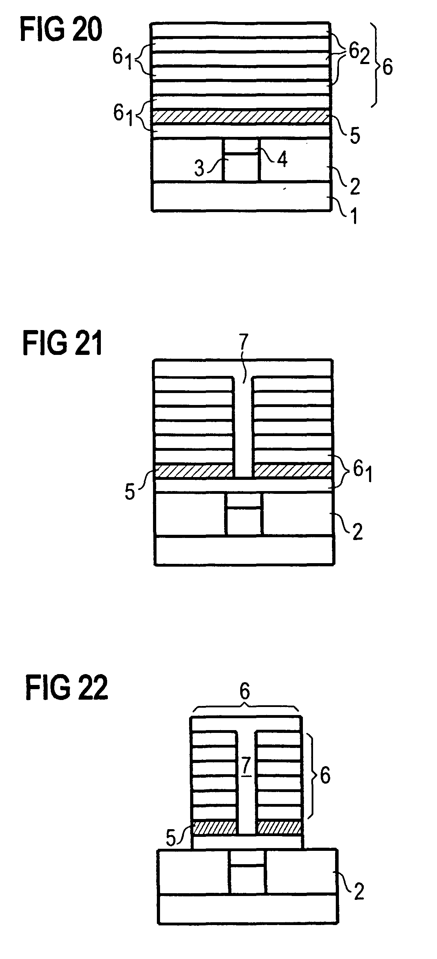

FIG 20: Bei diesem 6. Ausführungbeispiel ist der Einsatz einer Ätzstopschicht (TEOS, Nitrid) als zweitunterster Schicht der Schichtenfolge beschrieben.
Auf dem Träger wird eine Schichtenfolge mit einer Schicht 6₁ aus dem ersten Material als unterster Schicht und einer Ätzstopschicht 5 als zweitunterster Schicht aufgebracht, darauf werden alternierend Schichten aus dem ersten (6₁) und zweiten (6₂₎ Material aufgebracht.

FIG 21: In die Schichtenfolge wird eine Öffnung bis zur Ätzstopschicht 5 geätzt. Dazu kann bspw. ein RIE-Prozeß mit chlorhaltigen Gasen eingesetzt werden. In einem zweiten Ätzschritt wird die Ätzstopschicht 5 mit C₂F₆/CHF₃ durchgeätzt, so daß die Öffnung eine Oberfläche der untersten Schicht aus dem ersten Material freilegt. Der Ätzschritt wird selektiv zum ersten Material durchgeführt. Die Öffnung wird mit dem ersten Material aufgefüllt, vorzugsweise wird auch auf der horizontalen Oberfläche der Schichtenfolge das erste Material abgeschieden.

FIG 22: Anschließend wird in einem anisotropen Ätzprozeß die Schichtenfolge 6₁, 6₂ einschließlich der Ätzstopschicht 5 zur Schichtstruktur 6 strukturiert. Ggf. können dafür mehrere Ätzschritte durchgeführt werden. Neben der Schichtstruktur liegt die Trägeroberfläche 2 frei.

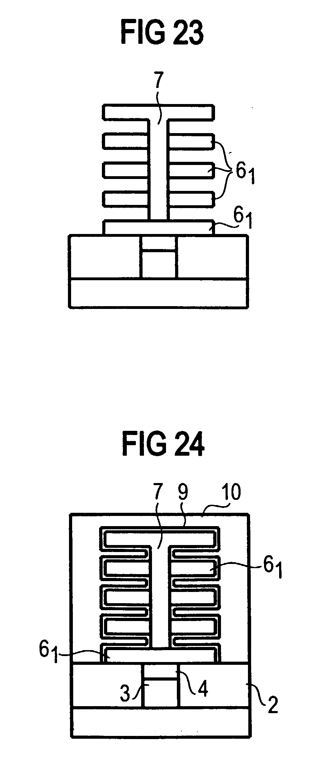

FIG 23: Das Freiätzen der Lamellen 6₁ erfolgt wie oben beschrieben, wobei die Ätzung selektiv zum ersten Material ist. Eine Selektivität zur Ätzstopschicht ist nicht erforderlich. Die Ätzstopschicht 5 wird ebenfalls entfernt. Geeignete isotrope Ätzprozesse für TEOS oder Nitrid sind dem Fachmann geläufig. Damit ist die erste Elektrode fertiggestellt. Die Lamellen 6₁ sind über die Stützstruktur mechanisch und elektrisch miteinander verbunden, der Kontakt mit der Anschlußstruktur 3, 4 erfolgt über die unterste Lamelle. Damit sind Dejustierungen zwischen der Stützstruktur und dem Anschluß unkritisch. Ohne Einsatz einer Ätzstopschicht kann die unterste Lamelle durchgeätzt werden und die Barriere 4 evtl. geschädigt werden.

FIG 24: Der Kondensator wird durch die Bildung des hoch-ε-Dielektrikum 9 oder Ferroelektrikum auf den freien Oberflächen und die Erzeugung der Gegenelektrode 10 fertiggestellt.

## Patentansprüche

1. Kondensator, der in einer Halbleiteranordnung auf einem Träger angeordnet ist,
- mit einer edelmetallhaltigen ersten Elektrode (6₁, 7),
- mit einem Kondensatordielektrikum (9), das aus einem hoch-ε-dielektrischen oder ferroelektrischen Material besteht,
- mit einer zweiten Elektrode (10),
**dadurch gekennzeichnet,** daß
die erste Elektrode (6₁, 7) mindestens zwei voneinander beabstandete Lamellen (6₁) aufweist, die im wesentlichen parallel zur Trägeroberfläche angeordnet sind und über eine Stützstruktur (7) miteinander mechanisch und elektrisch verbunden sind.

2. Kondensator nach Anspruch 1, bei dem die Lamellen (6₁) über die Stützstruktur (7) mit dem Träger (1, 2) elektrisch verbunden sind.

3. Kondensator nach Anspruch 2, bei dem die Stützstruktur (7) an mindestens einer Außenflanke der Lamellen (6₁) angeordnet ist.

4. Kondensator nach Anspruch 1 oder 2, bei dem die Stützstruktur (7) durch die Lamellen hindurch verläuft.

5. Kondensator nach einem der Ansprüche 1 bis 4, bei dem der Träger an seiner dem Kondensator zugewandten Oberfläche eine Isolierschicht (2) mit einem darin angeordneten Kontakt (3) aufweist, wobei der Kontakt (3) eine Diffusionsbarriere (4) umfaßt und mit der ersten Elektrode (6₁,7) verbunden ist.

6. Kondensator nach Anspruch 5, bei dem der Träger einen MOS-Transistor enthält und der Kontakt (3) ein S/D-Gebiet (11) des Transistors mit der ersten Elektrode (6₁, 7) verbindet.

7. Herstellverfahren für einen Kondensator nach Anspruch 1,
- bei dem auf der Oberfläche des Trägers (1, 2) eine Schichtenfolge erzeugt wird, die jeweils alternierend eine Schicht aus einem edelmetallhaltigen ersten Material (6₁) und eine Schicht aus einem zweiten Material (6₂) umfaßt, wobei das zweite Material selektiv zum ersten Material ätzbar ist,
- bei dem die Schichtenfolge zu einer Schichtstruktur (6) mit Flanken geätzt wird,
- bei dem eine Stützstruktur (7) gebildet wird, die mindestens eine Flanke der Schichtstruktur (6) bedeckt und die Schichten aus dem ersten Material mechanisch und elektrisch verbindet,
- bei dem die Schichten (6₂) aus dem zweiten Material selektiv zu den Schichten (6₁) aus dem ersten Material und zur Stützstruktur (7) entfernt werden,
- bei dem auf den freiliegenden Oberfläche der Schichten aus dem ersten Material und der Stützstruktur (6₁,7) ein Kondensatordielektrikum (9) aus einem hoch-ε-dielektrischen oder ferroelektrischen Material konform aufgebracht wird,
- bei dem eine zweite Elektrode (10) auf dem Kondensatordielektrikum erzeugt wird.

8. Verfahren nach Anspruch 7, bei dem die Stützstruktur mithilfe einer konformen Abscheidung des ersten Materials und anschließender anisotroper Rückätzung zu einem Spacer erzeugt wird, und bei dem dann eine Öffnung (8) in die Schichtstuktur geätzt wird, die eine Oberfläche der Schichten aus dem ersten und dem zweiten Material freilegt.

9. Verfahren nach Anspruch 8, bei dem die Öffnung an den Rand der Schichtstruktur (6) gelegt wird.

10. Verfahren nach Anspruch 8, bei dem die Öffnung in das Innere der Schichtstruktur gelegt wird, so daß die Stützstruktur an allen Außenflanken der Schichtstruktur verbleibt.

11. Verfahren nach Anspruch 8, bei dem bei der Bildung der Öffnung in der Schichtstruktur die Schichtstruktur mit der Stützstruktur in zwei Teilbereiche geteilt wird, die durch einen Spalt beabstandet sind, wobei jeder Teilbereich eine erste Elektrode eines Kondensators darstellt.

12. Verfahren nach Anspruch 7,
bei dem die Stützstruktur mithilfe eines anisotropen schrägen Aufdampfprozesses erzeugt wird.

13. Herstellverfahren für einen Kondensator nach Anspruch 1,
- bei dem auf der Oberfläche des Trägers (1, 2) eine Schichtenfolge erzeugt wird, die jeweils alternierend eine Schicht aus einem edelmetallhaltigen ersten Material (6₁) und eine Schicht aus einem zweiten Material (6₂) umfaßt, wobei das zweite Material selektiv zum ersten Material ätzbar ist,
- bei dem in der Schichtenfolge eine Öffnung gebildet wird,
- bei dem in der Öffnung eine Stützstruktur (7) gebildet wird, die die die Öffnung auffüllt
- bei dem die Schichtenfolge in einem anisotropen Ätzprozeß zu einer Schichtstruktur (6) mit innenliegender Stützstruktur geätzt wird,
- bei dem die Schichten (6₂) aus dem zweiten Material selektiv zu den Schichten (6₁) aus dem ersten Material und zur Stützstruktur (7) entfernt werden,
- bei dem auf den freiliegenden Oberfläche der Schichten aus dem ersten Material und der Stützstruktur (6₁,7) ein Kondensatordielektrikum (9) aus einem hoch-ε-dielektrischen oder ferroelektrischen Material konform aufgebracht wird
- bei dem eine zweite Elektrode (10) auf dem Kondensatordielektrikum (9) erzeugt wird.

14. Verfahren nach einem der Ansprüche 7 - 13,
- bei dem die Schichten (6₁) aus dem ersten Material aus Pt, Ir oder RuO und die Schichten (6₂) aus dem zweiten Material aus einem selektiv dazu ätzbaren Metall, insbesondere aus Al oder Ti, erzeugt werden.

15. Verfahren nach einem der Ansprüche 7 - 14, bei dem auf dem Träger (2) oder auf der untersten Schicht der Schichtenfolge eine Ätzstopschicht (5) aufgebracht wird.
